# EUROPÄISCHE PATENTANMELDUNG

(11) **EP 1 923 768 A2**
(43) Veröffentlichungstag der Anmeldung: **21.05.2008**
(21) Anmeldenummer: 07021161.0
(22) Anmeldetag: 30.10.2007
(51) Int. Cl.: G06F 1/18

(54) **Bedieneinrichtung für mindestens eine elektronische Datenverarbeitungsanlage und Schublade dafür**

(30) Priorität: 20.11.2006 DE 102006054887
(71) Anmelder: Infratec AG, 64625 Bensheim (DE)
(72) Erfinder: Knapp Karlheinz, 64625 Bensheim (DE)
(74) Vertreter: Katscher Habermann Patentanwälte

(57) **Zusammenfassung**

Eine Bedieneinrichtung für mindestens eine elektronische Datenverarbeitungsanlage (EDV-Anlage) mit mindestens zwei Eingabe- und/oder Ausgabegeräten (3) weist eine gemeinsame Schnittstelle (7) zu der EDV-Anlage (13) auf. Die gemeinsame Schnittstelle (7) ist ein erster Steckverbinder (8). Die Eingabe- und/oder Ausgaberäte (3) können mittels mindestens eines flexiblen Kabels (6) mit der gemeinsamen Schnittstelle (7) verbunden oder aber in einem gemeinsamen Gehäuse (4) angeordnet sein. Die Bedieneinrichtung weist eine Schublade (9) zur Aufnahme der Eingabe- und/oder Ausgabegeräte (3) auf. Die Schublade (9) weist einen an die gemeinsame Schnittstelle (7) der Eingabe- und/oder Ausgabegeräte (3) angepassten zweiten Steckverbinder (11) auf, der mittels elektrisch leitender Verbindungen (14, 16) mit den vorgesehenen Anschlusseinrichtungen der EDV-Anlage (13) für die Tastatur, den Bildschirm und gegebenenfalls weitere Eingabe- und/oder Ausgabegeräte sowie sonstige Peripheriegeräte verbindbar ist. Der zweite Steckverbinder (11) der Schublade (9) mit einem KVM-Switch (15) verbindbar ist. Eine Schublade zur Aufnahme von mindestens zwei Eingabe- und/oder Ausgabegeräten für EDV-Anlagen weist eine gemeinsame Schnittstelle zu den mindestens zwei Eingabe- und/oder Ausgabegeräten (3) aufweist.

## Beschreibung

Die Erfindung betrifft eine Bedieneinrichtung für mindestens eine elektronische Datenverarbeitungsanlage (EDV-Anlage) mit mindestens zwei Eingabe- und/oder Ausgabegeräten.

Für die Bedienung einer elektronischen Datenverarbeitungsanlage wurden verschiedene Eingabe- und Ausgabegeräte entwickelt, die eine einfache Kommunikation und Interaktion eines Benutzers mit der EDV-Anlage ermöglichen. In den meisten Fällen weisen die verwendeten Eingabe- und/oder Ausgabegeräte zumindest eine Tastatur und einen Bildschirm auf. In seltenen Fällen wird auf eine Tastatur verzichtet und stattdessen ausschließlich ein grafisches Eingabegerät oder ein berührungssensitiver Bildschirm verwendet, der gleichzeitig Eingabe und Ausgabe von Informationen ermöglicht. Im Folgenden wird jedoch vereinfachend von Tastatur und Bildschirm als Minimalkonfiguration der üblicherweise verwendeten Eingabe- und Ausgabegeräte ausgegangen. Auch werden sämtliche Geräte, die eine Eingabe und/oder Ausgabe von Informationen und damit eine Kommunikation mit der EDV-Anlage ermöglichen, vereinfachend als Eingabe- und/oder Ausgabegeräte bezeichnet. Die Eingabe von Informationen oder Steuerungsbefehlen kann dem Benutzer durch zusätzliche Eingabegeräte wie beispielsweise ein Touch Pad oder eine Maus erleichtert werden.

Die EDV-Anlage weist für die verschiedenen Eingabe- und/oder Ausgabegeräte jeweils gesonderte, oftmals genormte Schnittstellen auf. Die einzelnen Schnittstellen sind üblicherweise Steckverbinder, deren Formgebung und Kontaktanordnung zweckmäßigerweise für die betreffenden Eingabe- und/oder Ausgabegeräte standardisiert ist.

Es sind Anwendungsfälle bekannt, bei denen die aus mehreren Eingabe- und/oder Ausgabegeräten bestehende Bedieneinrichtung nicht dauerhaft mit einer EDV-Anlage verbunden sein muss oder kann. Ebenso ist es für manche Anwendungsgebiete denkbar oder vorteilhaft, dass eine Bedieneinrichtung wechselnd mit verschiedenen EDV-Anlagen verbunden und zeitweise zu deren Benutzung verwendet werden kann. Ein anschauliches Beispiel für derartige Anwendungsgebiete stellt beispielsweise ein Serverschrank mit mehreren, in dem Serverschrank angeordneten EDV-Anlagen dar. Solche Serverschränke sind beispielsweise in großer Anzahl in Rechenzentren großer Unternehmen und insbesondere in den Rechenzentren von Anbietern von Telekommunikationsdienstleistungen oder Internetdienstleistungen vorhanden. Nicht selten weisen derartige Rechenzentren viele Reihen mit jeweils einer großen Anzahl von nebeneinander aufgestellten Serverschränken auf, wobei jeder Serverschrank wiederum mehrere Server bzw. EDV-Anlagen enthält. Sowohl aus Kostengründen als auch zur Vermeidung unnötiger Platzverschwendung weisen die einzelnen EDV-Anlagen in den Serverschränken nicht jeweils eine gesonderte, mit der einzelnen EDV-Anlage dauerhaft verbundene Bedieneinrichtung auf.

Es ist aus der Praxis bekannt, eine gemeinsame Bedieneinrichtung für alle in einem Serverschrank angeordneten EDV-Anlagen in dem Serverschrank anzuordnen. Die Eingabe- und/oder Ausgabegeräte der Bedieneinrichtungen, zumindest jedoch eine Tastatur und ein Bildschirm, sind dabei üblicherweise über einen KVM-Switch (Keybord-Viedeo-Mouse-Switch) mit den einzelnen EDV-Anlagen verbunden, wobei der KVM-Switch jeweils mehrere gesonderte Verbindungsleitungen zu den einzelnen EDV-Anlagen aufweist und wahlweise eine elektrisch leitende Verbindung der einzelnen Komponenten der Bedieneinrichtung mit einer vorgegebenen EDV-Anlage ermöglicht. Derartige Bedieneinrichtungen sind üblicherweise dauerhaft in einen Serverschrank integriert und mit den einzelnen EDV-Anlagen verbunden. Nachteilig ist hierbei der nicht unerhebliche Kostenaufwand für die einem Serverschrank zugeordnete Bedieneinrichtung. Insbesondere bei Rechenzentren mit einer großen Anzahl von Serverschränken oder Netzwerkschränken entfällt ein nicht unerheblicher Anteil der Anschaffungskosten neuer EDV-Anlagen auf derartige, einem Serverschrank fest zugeordnete Bedieneinrichtungen.

Aus der Praxis ist es ebenfalls bekannt, auf derartige Bedieneinrichtungen zu verzichten, die in einen Serverschrank integriert sind. Stattdessen muss das Bedienpersonal die erforderlichen Eingabe- und/oder Ausgabegeräte mit sich führen und bei Bedarf, beispielsweise zu Wartungs- oder Konfigurationsaufgaben, mit der betreffenden EDV-Anlage verbinden. Der Vorteil erheblich geringerer Anschaffungskosten für die erforderlichen Bedieneinrichtungen wird oftmals durch die umständliche und erschwerte Handhabung und dem zusätzlichen Aufwand bei der Wartung und Konfiguration der EDV-Anlagen ins Gegenteil verkehrt und führt zu erhöhten Kosten während des Betriebs und der Wartung der EDV-Anlagen. Sofern auch auf die Verwendung von KVM-Switches verzichtet wird, müssen die einzelnen Komponenten einer solchen mobilen Bedieneinrichtung jeweils mit den zugeordneten Anschlüssen der betreffenden EDV-Anlage verbunden werden, was sich auf Grund der nicht notwendigerweise einheitlichen Geräteabmessungen und Bauformen und den zahlreichen, zum Teil bereits belegten Anschlüssen der in einem Serverschrank kombinierten EDV-Anlagen als äußerst schwierig und zeitraubend erweisen kann.

Aufgabe der vorliegenden Erfindung ist es demzufolge, mit einfachen Mitteln eine kostengünstige Bedieneinrichtung zur Verfügung zu stellen, die schnell und mit geringem Aufwand mit einer oder mehreren EDV-Anlagen verbindbar ist und genutzt werden kann.

Diese Aufgabe wird erfindungsgemäß dadurch gelöst, dass die Eingabe- und/oder Ausgabegeräte eine gemeinsame Schnittstelle zu der EDV-Anlage aufweisen. Eine gemeinsame Schnittstelle für die Tastatur und den Bildschirm kann auf Grund der weithin standardisierten Anschlüsse für die verschiedenen Eingabe- und Ausgabegeräte in einfacher Weise und kostengünstig bereitgestellt werden. Da für den Anschluss der Bedieneinrichtung an der EDV-Anlage lediglich eine gemeinsame Schnittstelle verbunden werden muss, vermindert sich der hierfür erforderliche Aufwand erheblich.

Der für eine Verbindung der Bedieneinrichtung mit einer EDV-Anlage anfallende Aufwand kann weiter dadurch vermindert werden, dass die Bedieneinrichtung eine Maus oder ein kabelloses Eingabegerät aufweist, wobei das zusätzliche Eingabe- oder Ausgabegerät ebenfalls mit der gemeinsamen Schnittstelle verbunden ist. In gleicher Weise können weitere Eingabe- und/oder Ausgabegeräte in der Bedieneinrichtung kombiniert und mit der gemeinsamen Schnittstelle verbunden sein.

Es ist ebenso denkbar, weitere Peripheriegeräte wie beispielsweise Speichermedien in die Bedieneinrichtung zu integrieren, bzw. mit der gemeinsamen Schnittstelle zu verbinden. So können beispielsweise im Bedarfsfall Testprogramme von einem Speichermedium abgerufen und in der EDV-Anlage ausgeführt werden oder für eine externe Auswertung relevante Daten auf ein Speichermedium übertragen werden.

Vorzugsweise ist vorgesehen, dass die gemeinsame Schnittstelle ein Steckverbinder ist. Der Steckverbinder kann dabei entweder eine bereits bekannte und gegebenenfalls normierte Formgebung und Kontaktbewegung aufweisen oder aber ein beispielsweise besonders raumsparendes oder besonders zuverlässiges proprietäres Format aufweisen.

Einer Ausgestaltung des Erfindungsgedankens zufolge ist vorgesehen, dass die Eingabe- und Ausgabegeräte mittels mindestens eines flexiblen Kabels mit der gemeinsamen Schnittstelle verbindbar sind. Kabellängen von mehreren Metern beeinträchtigen bei Verwendung geeigneter Kabel die Signalübertragung zwischen der Tastatur oder dem Bildschirm bzw. beliebigen Eingabe- oder Ausgabegeräten und der gemeinsamen Schnittstelle nicht merklich. Die Verwendung eines oder mehrerer Kabel zur Verbindung der Eingabe- und/oder Ausgabegeräte mit der gemeinsamen Schnittstelle ermöglicht jedoch eine für den Benutzer zweckmäßige und angenehme Anordnung der Eingabe- und/oder Ausgabegeräte unabhängig von der Anordnung der gemeinsamen Schnittstelle, die üblicherweise durch die Anordnung der EDV-Anlagen vorgegeben ist.

Gemäß einer besonders vorteilhaften Ausgestaltung des Erfindungsgedankens ist vorgesehen, dass die Bedieneinrichtung eine Schublade zur Aufnahme der Eingabe- und/oder Ausgabegeräte aufweist. Die Schublade ist zweckmäßigerweise für den Einbau in standardisierte Serverschränke vorgesehen und in ihren Abmessungen an die gängigen Einbauformate angepasst. Bekannte und häufig verwendete Abmessungen von Netzwerk- und Serverschränken sind normierte Standard-Racks mit einer Breite von 19 Zoll und einer Tiefe von beispielsweise 60 cm, 80 cm, 90 cm oder 100-120 cm. Eine übliche Höheneinheit für EDV-Anlagen oder andere Baugruppen, die in derartigen 19-Zoll-Racks montiert werden können, beträgt 1,75 Zoll (4,45 cm).

Es hat sich als vorteilhaft herausgestellt, die Schublade zur Aufnahme der einzelnen Eingabe- und Ausgabegeräte hinsichtlich Breite und Tiefe an die Abmessungen der verwendeten Standard-Racks für Serverschränke anzupassen und die Schublade eine Höheneinheit (4,45 cm) hoch auszugestalten. Die Schublade weist dann zweckmäßigerweise eine Ausnehmung auf, die ausreichend groß ist, um die Tastatur, den Bildschirm und gegebenenfalls weitere Eingabe- oder Ausgabegeräte bequem aufnehmen zu können. In den meisten Fällen wird dabei als Bildschirm ein TFT-Monitor oder ein anderer Flachbildschirm verwendet werden.

In vorteilhafter Weise ist vorgesehen, dass die Eingabe- und/oder Ausgabegeräte sowie die gemeinsame Schnittstelle in einem gemeinsamen Gehäuse angeordnet und zugänglich sind. Die einzelnen Komponenten können dabei in eine Bedienkonsole zusammengefasst werden, die äußerlich ähnlich wie ein Laptop gestaltet ist und genutzt werden kann, jedoch ausschließlich die verschiedenen Eingabe- und/oder Ausgabegeräte aufweist und keine eigene Recheneinheit oder EDV-Anlage enthält. Diese Bedienkonsole enthält dann bereits die gemeinsame Schnittstelle. Es ist auch denkbar, dass die Bedienkonsole über ein gesondertes Kabel mit der gemeinsamen Schnittstelle verbunden werden kann.

Zweckmäßigerweise ist vorgesehen, dass die Schublade einen an die gemeinsame Schnittstelle der Eingabe- und/oder Ausgabegeräte angepassten zweiten Steckverbinder aufweist, der mittels elektrisch leitender Verbindungen mit den vorgesehenen Anschlusseinrichtungen der EDV-Anlage für die Tastatur, den Bildschirm und gegebenenfalls weitere Eingabe- und/oder Ausgabegeräte oder sonstigen Peripheriegeräten verbindbar ist. Um mit einer beispielsweise in einem Serverschrank angeordneten EDV-Anlage verbunden zu werden, muss der Steckverbinder der gemeinsamen Schnittstelle der Bedieneinrichtung lediglich mit dem daran angepassten zweiten Steckverbinder der Schublade verbunden werden, der seinerseits bereits mit der EDV-Anlage verbunden ist. Die Suche und Ermittlung der für die einzelnen EDV-Anlagen jeweils zur Verfügung stehenden Anschlusseinrichtungen und deren Verbindung wird dadurch überflüssig.

Eine derartige Bedienkonsole kann einen Steckverbinder der gemeinsamen Schnittstelle aufweisen, der direkt und ohne Verwendung einer zusätzlichen flexiblen Kabelverbindung mit dem zweiten Steckverbinder der Schublade verbindbar ist. Dazu weist die Bedienkonsole beispielsweise an der Unterseite oder der Rückseite einen an den Steckverbinder der Schublade angepassten Steckverbinder auf. Die beiden Steckverbinder sind zweckmäßigerweise so angeordnet und ausgerichtet, dass bei einem Einführen der Bedienkonsole in die Aussparung der Schublade die Steckverbinder miteinander verbunden werden.

Vorzugsweise ist vorgesehen, dass der Steckverbinder der Schublade mit einem KVM-Switch verbindbar ist. Zweckmäßigerweise wird für jeden Serverschrank ein gesonderter KVM-Switch vorgesehen, dessen abwechselnd anwählbaren Ausgänge jeweils gesondert mit den vorgesehenen Anschlusseinrichtungen für die Tastatur, den Bildschirm und gegebenenfalls weitere Eingabe- und/oder Ausgabegeräte einer jeden EDV-Anlage in dem Serverschrank verbunden sind. Die gemeinsamen Eingangsanschlüsse des KVM-Switchs sind mit dem zweiten Steckverbinder der Schublade verbunden. Zweckmäßigerweise wird eine ausreichend lange Kabelverbindung zwischen dem zweiten Steckverbinder der Schublade und dem KVM-Switch vorgesehen, so dass die Schublade vollständig ausgezogen werden kann, ohne dass die Verbindung des zweiten Steckverbinders der Schublade mit dem KVM-Switch unterbrochen oder beeinträchtigt wird. Um die Bedienkonsole mit einer beliebigen EDV-Anlage innerhalb des Serverschranks zu verbinden und zu benutzen, muss lediglich der Steckverbinder der gemeinsamen Schnittstelle der Bedienkonsole mit dem zweiten Steckverbinder der Schublade verbunden werden und über den KVM-Switch die gewünschte EDV-Anlage angewählt werden.

Es ist auch denkbar, die gemeinsamen Eingangsanschlüsse des KVM-Switchs mittels eines Splitters aufzuteilen und sowohl auf der Vorderseite des Serverschranks als auch auf der Rückseite des Serverschranks jeweils eine ausziehbare Schublade zur Aufnahme einer Bedienkonsole oder aber angepasste Steckverbinder für eine Verbindung mit der gemeinsamen Schnittstelle der Bedienkonsole vorzusehen. Die Bedienkonsole kann dann wahlweise an der Vorderseite oder an der Rückseite des Serverschranks mit den darin enthaltenen EDV-Anlagen verbunden und benutzt werden. Es kann für einige Anwendungen oder Ausführungen auch zweckmäßig sein, auf die Schublade zu verzichten und lediglich an der Vorderseite und/oder Rückseite des Serverschranks einen Steckverbinder anzuordnen, der einen Anschluss der Bedienkonsole ermöglicht.

Die Erfindung betrifft auch eine Schublade zur Aufnahme von mindestens zwei Eingabe- und/oder Ausgabegeräten für EDV-Anlagen. Erfindungsgemäß weist die Schublade eine gemeinsame Schnittstelle zu den mindestens zwei Eingabe- und/oder Ausgabegeräten auf. Vorzugsweise ist vorgesehen, dass die gemeinsame Schnittstelle ein Steckverbinder ist.

Um einen einfachen Anschluss einer in der Schublade aufgenommenen oder mit dieser verbundenen Bedienkonsole mit mehreren EDV-Anlagen zu ermöglichen, ist vorgesehen, dass der Steckverbinder der Schublade mit einem KVM-Switch verbindbar ist.

Derartige Schubladen können in vorteilhafter Weise in Rechenzentren mit einer großen Anzahl von Serverschränken verwendet werden. Es ist nicht notwendig, in jeden Serverschrank eine diesem Serverschrank zugeordnete und dauerhaft mit diesem Serverschrank verbundene Bedienkonsole zuzuordnen, wie sie vorangehend beschrieben ist. Es ist in den meisten Fällen für eine schnelle und einfache Bedienung, Wartung und Konfiguration der in den Serverschränken angeordneten EDV-Anlagen ausreichend, wenn lediglich einige der Serverschränke eine in einer Schublade aufgenommene Bedienkonsole aufweisen und die überwiegende Anzahl der Serverschränke lediglich eine leere Schublade aufweisen, die zur Aufnahme einer Bedienkonsole gedacht und vorgesehen ist und die erforderliche gemeinsame Schnittstelle für die mindestens zwei Eingabe- und/oder Ausgabegeräte aufweist.

Werden die Bedienkonsole getrennt von der Schublade, bzw. dem Serverschrank aufbewahrt und bis auf die gemeinsame Schnittstelle sämtliche Anschlüsse unzugänglich gemacht, so stellt dies eine zusätzliche Sicherheit dar. Ohne die Bedienkonsole mit dem dort verwendeten, gegebenenfalls proprietären Steckverbinder ist eine Verbindung von Eingabe- und/oder Ausgabegeräten mit den einzelnen EDV-Anlagen in dem Serverschrank nicht möglich. Eine unbefugte Bedienung der EDV-Anlagen kann demzufolge allein durch Wegschließen der Bedienkonsole erheblich erschwert werden, ohne dass zusätzliche Sicherungsmaßnahmen erforderlich wären.

Nachfolgend werden Ausführungsbeispiele des Erfindungsgedankens näher erläutert, die in der Zeichnung dargestellt sind. Es zeigt:
Fig. 1 eine schematische Darstellung einer Bedieneinrichtung mit einer Tastatur und einem Bildschirm und einer Schublade zur Aufnahme dieser Eingabe- und Ausgabegeräte,
Fig. 2 eine schematische Seitenansicht eines Serverschranks mit einer Schublade zur Aufnahme von Eingabe- und/oder Ausgabegeräten der Bedieneinrichtung und mit einem mit der Schublade verbundenen KVM-Switch, und
Fig. 3 eine schematische Darstellung mehrerer nebeneinander angeordneter Serverschränke, die jeweils eine Schublade zur Aufnahme der Eingabe- und/oder Ausgabegeräte einer Bedieneinrichtung aufweisen, sowie einer zur Veranschaulichung beispielhaft getrennt von den Schubladen dargestellten Bedienkonsole mit einer Tastatur und einem Bildschirm.

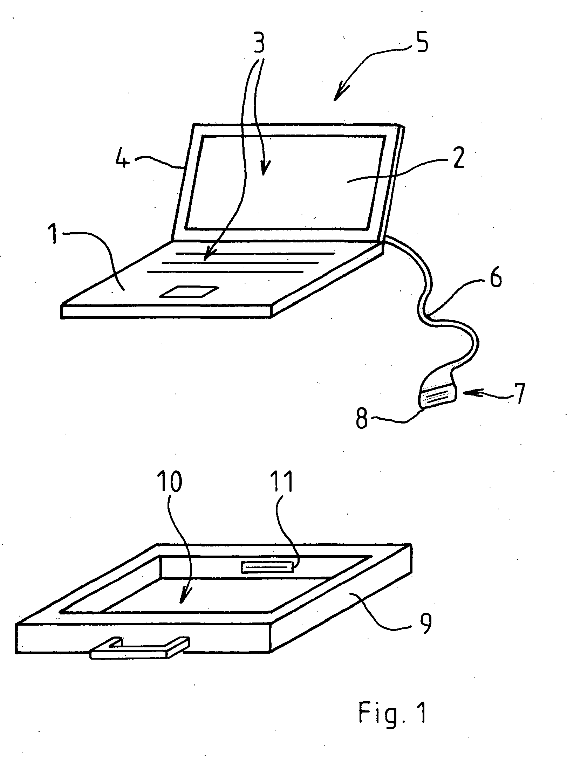

In Fig. 1 sind schematisch eine Tastatur 1 und ein Bildschirm 2 als beispielhafte Kombination von Eingabe- und/oder Ausgabegeräten 3 dargestellt. Die Tastatur 1 und der Bildschirm 2 sind in einem Gehäuse 4 angeordnet, welches in seiner Formgebung und Handhabung mit einem Laptop-Gehäuse vergleichbar ist. Die in dem Gehäuse 4 angeordnete Tastatur 1 und der Bildschirm 2 werden gemeinsam als Bedienkonsole 5 bezeichnet. Der Bildschirm 2 ist ein TFT-Bildschirm, wobei auch andere Flachbildschirme Verwendung finden können.

Die Eingabe- und/oder Ausgabegeräte 3 sind über ein Kabel 6 mit einer gemeinsamen Schnittstelle 7 elektrisch leitend verbunden. Die gemeinsame Schnittstelle 7 ist als Steckverbinder 8 ausgestaltet. Der Steckverbinder 8 weist zweckmäßigerweise eine genormte Formgebung auf, so dass handelsübliche Steckverbinderelemente verwendet werden können. In dem schematisch dargestellten Ausführungsbeispiel wird ein Centronics-Stecker als Steckverbinder 8 verwendet.

In der Fig. 1 ist zur Verdeutlichung eine Schublade 9 zur Aufnahme der Eingabe- und/oder Ausgabegeräte 3 getrennt von der Bedienkonsole 5 dargestellt. Die Schublade 9 weist eine Ausnehmung 10 zur Aufnahme des Gehäuses 4 der Eingabe- und Ausgabegeräte 3 einschließlich des damit verbundenen Kabels 6 und des Steckverbinders 8 auf. Die Schublade 9 weist darüber hinaus einen zweiten Steckverbinder 11 auf, der an den Steckverbinder 8 angepasst und elektrisch leitend mit diesem verbindbar ist. Die Schublade 9 bzw. der zweite Steckverbinder 11 in der Schublade 9 können mit den Anschlusseinrichtungen einer in Fig. 1 nicht dargestellten EDV-Anlage für eine Tastatur, für einen Bildschirm sowie gegebenenfalls für weitere Eingabe- oder Ausgabegeräte verbunden werden.

Die Abmessungen der Schublade 9 sind an handelsübliche Serverschränke oder Netzwerkschränke, üblicherweise 19-Zoll-Racks mit einer Tiefe von 60 cm, 80 cm, 90 cm oder 100-120 cm angepasst. Insbesondere bei 19-Zoll-Recks mit einer Tiefe von mehr als 80 cm kann die Tiefe der Schublade 9 ohne Einschränkungen für die Bedienung auf weniger als die Hälfte der Tiefe des 19-Zoll-Racks begrenzt werden, so dass an der für einen Einbau der Schublade 9 vorgesehenen Höhe sowohl an der Vorderseite als auch an der Rückseite eines Serverschrankes eine Schublade 9 ausziehbar montiert werden kann. Auf diese Weise wird mit geringem Aufwand eine Bedienung sowohl von der Vorderseite als auch von der Rückseite des Serverschrankes aus ermöglicht.

Zur Aufbewahrung oder während einer Benutzung der Eingabe- und/oder Ausgabegeräte 3 kann das Gehäuse 4 in der dafür vorgesehenen Ausnehmung 10 der Schublade 9 angeordnet und die gemeinsame Schnittstelle 7 der Eingabe- und/oder Ausgabegeräte 3, also der Steckverbinder 8 mit dem in der Schublade 9 angeordneten zweiten Steckverbinder 11 verbunden werden. Die Informationen und Steuerbefehle, welche durch die Eingabe- und Ausgabegeräte 3 übermittelt bzw. empfangen werden, werden dann über das Kabel 6 und die gemeinsame Schnittstelle 7 sowie über die Schublade 9 bis zu der zugeordneten, auf herkömmliche Art und Weise in getrennten Kabelanschlüssen mit der Schublade 9 verbundenen EDV-Anlage übermittelt.

Abweichend von dem in Fig. 1 dargestellten Ausführungsbeispiel kann der Steckverbinder 8 der gemeinsamen Schnittstelle 7 bereits unmittelbar an dem Gehäuse 4 der Bedienkonsole 5 angeordnet sein. Ein Kabel 6 ist in diesem Fall nicht mehr notwendig. Der Steckverbinder 8 sowie der zweite Steckverbinder 11 in der Schublade 9 sind dann zweckmäßigerweise so angeordnet und ausgerichtet, dass bei einem vollständigen Einführen der Bedienkonsole 5 in die Ausnehmung 10 der Schublade 9 ein leitender Kontakt zwischen den beiden Steckverbindern 8 und 11 hergestellt wird.

Die Ausnehmung 10 kann auch eine Öffnung an der Frontseite der Schublade 9 aufweisen, so dass auch bei geschlossener Schublade 9 die Bedienkonsole 5 von vorne in die Schublade 9 eingeführt oder aus dieser entnommen werden kann. Gegebenenfalls kann vorgesehen sein, mittels einer lösbaren Rastvorrichtung die Bedienkonsole 5 in einer Endposition in der Ausnehmung 10 der Schublade 9 festzulegen und zurückzuhalten. Die Bedienkonsole 5 kann ihrerseits an einer Frontseite einen Griff aufweisen, so dass eine einfache Handhabung der Bedienkonsole 5 erleichtert wird.

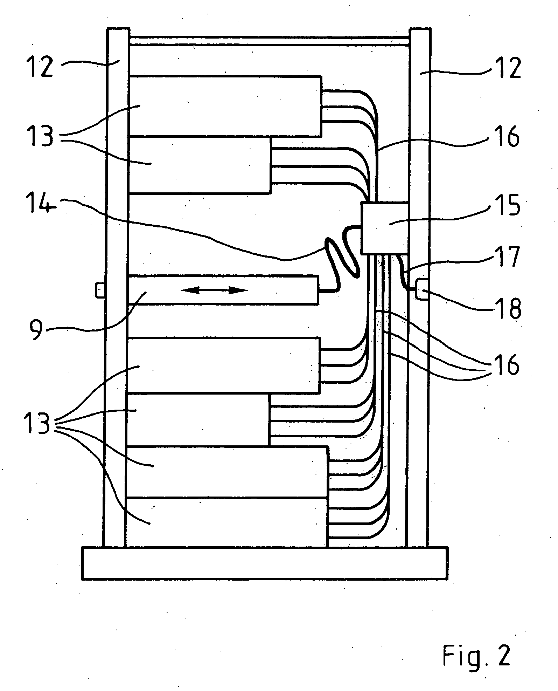

In Fig. 2 ist schematisch eine Seitenansicht eines Serverschrankes 12 dargestellt, in welchem mehrere EDV-Anlagen 13 angeordnet sind. In einer für einen Benutzer angenehmen Arbeitshöhe ist ausziehbar die Schublade 9 zur Aufnahme der Eingabe- und/oder Ausgabegeräte 3 angeordnet. Die Schublade 9 ist über mehrere Kabelverbindungen 14 elektrisch leitend mit einem KVM-Switch 15 verbunden. Von dem KVM-Switch 15 gehen handelsübliche Kabelverbindungen 16 für die jeweils erforderlichen Eingabe- und Ausgabegeräte 3 zu den verschiedenen EDV-Anlagen 13. Der KVM-Switch 15 weist einen nicht dargestellten mechanisch oder elektronisch betätigbaren Schalter auf, mit welchem die mit der Schublade 9 verbundenen eingangsseitigen Kabelverbindungen 14 elektrisch leitend mit den handelsüblichen Kabelverbindungen 16 und den zugeordneten Anschlusseinrichtungen der von einem Benutzer gewählten EDV-Anlage 13 verbunden werden.

Der KVM-Switch 15 ist über eine oder mehrere weitere Kabelverbindungen 17 mit einem an der Rückseite des Serverschrankes 12 angeordneten und von außen zugänglichen Steckverbinder 18 elektrisch leitend verbunden. Die gemeinsame Schnittstelle 8 der Bedienkonsole 5 kann entweder direkt oder über das Kabel 6 mit dem Steckverbinder 18 verbunden werden, so dass auch eine Bedienung der in dem Serverschrank 12 angeordneten EDV-Anlagen 13 von der Rückseite des Serverschrankes 12 aus möglich ist. Sofern ausreichend Platz in dem Serverschrank 12 vorhanden ist kann auch eine weitere Schublade 9 in dem Serverschrank 12 angeordnet sein, die auf der Rückseite des Serverschrankes 12 ausziehbar ist.

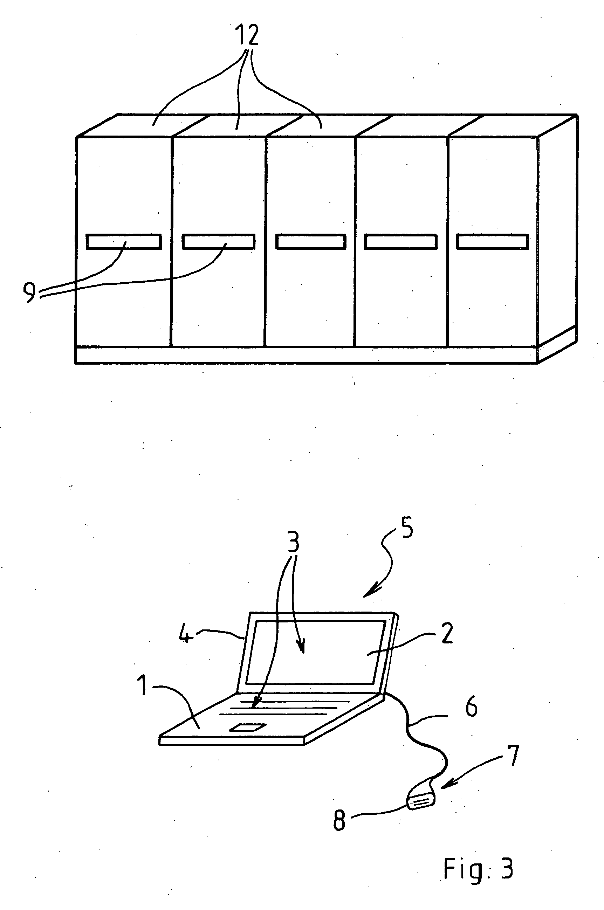

In Fig. 3 wird lediglich beispielhaft eine Anzahl von nebeneinander errichteten Serverschränken 12 dargestellt, die jeweils eine Schublade 9 zur Aufnahme der in einem Gehäuse 4 angeordneten Eingabe- und/oder Ausgabegerät 3 aufweisen. Aus Kostengründen können die einzelnen Schubladen 9 der mehreren Serverschränke 12 leer sein und lediglich die Aufnahme und den Anschluss einer gemeinsam nutzbaren Bedienkonsole 5 ermöglichen.

Die gemeinsam nutzbare Bedienkonsole 5 ist zur Veranschaulichung getrennt von den Serverschränken 12 dargestellt und weist die bereits beschriebenen Eingabe- und/oder Ausgabegeräte 3 in dem Gehäuse 4 auf, die über das Kabel 6 mit der gemeinsamen Schnittstelle 7 verbunden sind.

Für die Bedienung sämtlicher in den nebeneinander angeordneten Serverschränken 12 befindlichen EDV-Anlagen 13, beispielsweise zu Wartungs- oder Konfigurationszwecken, muss der Benutzer lediglich die Bedienkonsole 5 mit der entsprechenden Schublade 9 des betreffenden Serverschrankes 12 verbinden und den in dem Serverschrank 12 angeordneten KVM-Switch 15 auf die gewünschte EDV-Anlage 13 einstellen. Die Bedienkonsole 5 kann nach erfolgter Benutzung entweder in einer der verschiedenen Schubladen 9 verbleiben oder aber an einem gesonderten Ort aufbewahrt werden. Um das Wiederauffinden der in einer von mehreren Schubladen 9 aufbewahrten Bedienkonsole 5 zu erleichtern kann diejenige Schublade 9, welche die Bedienkonsole 5 enthält, eine entsprechende Anzeige oder Markierung aufweisen.

## Patentansprüche

1. Bedieneinrichtung für mindestens eine elektronische Datenverarbeitungsanlage (EDV-Anlage) mit mindestens zwei Eingabe- und/oder Ausgabegeräten für EDV-Anlagen, **dadurch gekennzeichnet, dass** die Eingabe- und/oder Ausgabegeräte (3) eine gemeinsame Schnittstelle (7) zu der EDV-Anlage (13) aufweisen.

2. Bedieneinrichtung nach Anspruch 1, **dadurch gekennzeichnet, dass** die gemeinsame Schnittstelle (7) ein erster Steckverbinder (8) ist.

3. Bedieneinrichtung nach Anspruch 1 oder Anspruch 2, **dadurch gekennzeichnet, dass** die Eingabe- und/oder Ausgaberäte (3) mittels mindestens eines flexiblen Kabels (6) mit der gemeinsamen Schnittstelle (7) verbindbar sind.

4. Bedieneinrichtung nach einem der vorangehenden Ansprüche, **dadurch gekennzeichnet, dass** die Eingabe- und/oder Ausgabegeräte (3) sowie die gemeinsame Schnittstelle (7) in einem gemeinsamen Gehäuse (4) angeordnet und zugänglich sind.

5. Bedieneinrichtung nach einem der vorangehenden Ansprüche, **dadurch gekennzeichnet, dass** die Eingabe- und/oder Ausgabegeräte (3) eine Maus, ein Touch Pad oder ein anderes grafisches Eingabe- oder Ausgabegerät oder ein sonstiges Peripheriegerät aufweisen.

6. Bedieneinrichtung nach einem der vorangehenden Ansprüche, **dadurch gekennzeichnet, dass** die Bedieneinrichtung eine Schublade (9) zur Aufnahme der Eingabe- und/oder Ausgabegeräte (3) aufweist.

7. Bedieneinrichtung nach Anspruch 6, **dadurch gekennzeichnet, dass** die Schublade (9) einen an die gemeinsame Schnittstelle (7) der Eingabe- und/oder Ausgabegeräte (3) angepassten zweiten Steckverbinder (11) aufweist, der mittels elektrisch leitender Verbindungen (14, 16) mit den vorgesehenen Anschlusseinrichtungen der EDV-Anlage (13) für die Tastatur, den Bildschirm und gegebenenfalls weitere Eingabe- und/oder Ausgabegeräte oder sonstige Peripheriegeräte verbindbar ist.

8. Bedieneinrichtung nach Anspruch 7, **dadurch gekennzeichnet, dass** der zweite Steckverbinder (11) der Schublade (9) mit einem KVM-Switch (15) verbindbar ist.

9. Schublade zur Aufnahme von mindestens zwei Eingabe- und/oder Ausgabegeräten für EDV-Anlagen, **dadurch gekennzeichnet, dass** die Schublade (9) eine gemeinsame Schnittstelle zu den mindestens zwei Eingabe- und/oder Ausgabegeräten (3) aufweist.

10. Schublade nach Anspruch 9, **dadurch gekennzeichnet, dass** die gemeinsame Schnittstelle ein zweiter Steckverbinder (11) ist.

11. Schublade nach Anspruch 10, **dadurch gekennzeichnet, dass** der zweite Steckverbinder (11) mit einem KVM-Switch (15) verbindbar ist.
